(19) **Europäisches Patentamt**
**European Patent Office**
**Office européen des brevets**

(11) **EP 4 386 394 B1**

(12) **EUROPEAN PATENT SPECIFICATION**

(45) Date of publication and mention
of the grant of the patent:
**02.07.2025 Bulletin 2025/27**

(51) International Patent Classification (IPC):
*G01R 31/11* *(2006.01)*        *G01R 27/16* *(2006.01)*
*G01R 27/04* *(2006.01)*        *G01R 19/25* *(2006.01)*

(21) Application number: **22383203.1**

(22) Date of filing: **13.12.2022**

(52) Cooperative Patent Classification (CPC):
**G01R 31/11; G01R 19/2513; G01R 27/04;**
**G01R 27/16**

(54) **CONDITION MONITORING METHOD OF AN ELECTRIC CONDUCTOR**

VERFAHREN ZUR ZUSTANDSÜBERWACHUNG EINES ELEKTRISCHEN LEITERS

PROCÉDÉ DE SURVEILLANCE DE L'ÉTAT D'UN CONDUCTEUR ÉLECTRIQUE

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**

(43) Date of publication of application:
**19.06.2024 Bulletin 2024/25**

(73) Proprietor: **Universitat Politècnica De Catalunya**
**08034 Barcelona (ES)**

(72) Inventors:
• **ALBERNAZ LACERDA FREITAS, Vinícius**
**08028 Barcelona (ES)**

• **GOMIS BELLMUNT, Oriol**
**08028 Barcelona (ES)**
• **CHEAH MAÑÉ, Marc**
**08028 Barcelona (ES)**
• **PRIETO ARAUJO, Eduardo**
**08028 Barcelona (ES)**

(74) Representative: **Torner, Juncosa I Associats, SL**
**C / Pau Claris, 108, 1r 1a**
**08009 Barcelona (ES)**

(56) References cited:
**WO-A1-2019/112258      US-A- 5 650 728**
**US-A1- 2017 199 237      US-B2- 7 977 950**

## Description

<u>Technical Field</u>

The present invention relates to a condition monitoring method of an electric conductor. More specifically, the method is based on performing a time-domain estimation of the characteristic admittance of the electric conductor.

<u>Background of the Invention</u>

Current fault locators find a fault using time-domain reflectometry (TDR), based on reflections of travelling waves into the fault. They are based on the fact that, when there is a discontinuity in the cable, a reflection will occur. If the time between two reflections is measured and the line/cable travelling wave speed is known, the distance to the discontinuity can be estimated.

Some of the pros of TDR is that it provides precise location if fast sampling is used (precision between two towers). Moreover, the calculations needed are simple, not requiring complicated mathematical models. On the other hand, this type of measurement has problems with weak discontinuities (high-impedance faults) or distributed distortions (a section of the cable damaged). Likewise, it is not preventive since it cannot discover if the insulation is degrading before it breaks. It can neither find multiple small degradations along the cable because it cannot deal with multiple reflections.

There are known some patents and patent applications to locate faults in electric conductors.

US5650728-A provides a fault detection system that uses a capacitor to discharge into a line and analyses the response by determining the admittance as a function of frequency, using the Fast Fourier Transform of both current and voltage signals. The invention requires medium voltage levels (10 kV) to initiate breakdown at possible insulate gaps and thus find high-impedance faults on distribution laterals. The proposed system and invention focus on detecting fault spots and thus do not provide any information about the line/cable condition. As a fault detection method, it focus on finding existing hard faults and thus cannot anticipate possible failures, as present invention does.

US7977950-B2 provides a time-domain reflectometer (TDR) for testing electrical cables that may be faulty. It works by sending an electrical into the cable under test and processing the reflected response. The method uses an insertion resistor to match the cable's impedance and uses an estimate of the cable's admittance to filter the reflected signal to better highlight any discontinuity in the cable. In faulty cables, the pulse travelling along the cable will be reflected at the fault and thus creating a spike in the measured variables (weaker than the generated pulse). By using the estimated travelling wave speed in the analysed cable, the fault location can be estimated. However, this method focus on precisely pinpointing the fault location and does not intend to provide an estimate of the cable's characteristics along its length. Moreover, this method is normally used to find hard faults in cables, being not effective in soft faults or slight variations of the conductor. Present invention, instead, focuses on the conductor characteristics, not on the fault location. Present invention provides a picture of the conductor's characteristics along its length and can display soft and continuous variations of the cable's characteristics along its length.

DE102017214996-A1 estimates the distance between the proposed apparatus and a reflection point (e.g. a fault or an open circuit). The method works by injecting into the line under test a ramp or sawtooth wave with increasing frequency between 30 kHz and 500 kHz and with a power between 50 W and 150 W. The distance to the reflection point is estimated by multiplying half of the propagation velocity by the frequency difference between the injected and reflected signal and dividing it by the time derivative of the frequency. The method fits in the category of fault location; thus it estimates the distance to the fault point, not providing any information about the conductor under test. Present invention, instead, monitors the conductor's characteristics along its length and does not assume a fault took place.

CN113253049-A provides a fault location method based on the spread-spectrum time-domain reflectometry (SSTDR). The SSTDR works by sending spread spectrum signals into a cable and correlating the reflected signal with the sent signal. The SSTDR operates well in high-noise environments and can be applied to live wires. However, the invention focuses on finding the fault spot, and was not evaluated from distributed soft faults along the cable.

CN106383296-B provides a fault location method for active power distribution networks. The method is based on synchronized phasor data from multiple points of the network, provided by Phasor Measurement Units (PMUs). The synchronized phasors are fed into a power flow algorithm which defines a plurality of possible fault points located on different line sections. The fault location only starts after the distribution automation master station receives a trigger from the protection action, meaning that a fault was detected. Therefore, the method fits in the conventional fault location category, not being proactive to identify the variation of the conductors' characteristics. Present invention, instead, focuses on assessing the health of the conductor before the hard fault occurs, thus possessing a proactive characteristic.

CN103018627-B discloses an adaptive fault detection method for distribution networks. The method applies the Wavelet Packet Decomposition (WPD) to the transient zero-sequence current of each line. The method is triggered if the zero-sequence voltage at a defined point exceeds a predefined threshold. The three lines with higher zero-sequence current envelope are taken as possible fault lines and for these, a scaling factor named r and a transient factor named h are calculated and used together with other polarity-based criteria to define the faulted line. The fault detection method does not provide any information about the characteristics of the network conductors, and focuses only in discriminating the fault line in a distribution network. Present invention, instead, provides the state of the conductors before the fault takes place.

CN113075501-B provides a fault location method based on a cable's impedance spectrum. The method works by acquiring the average phase velocity of the cable and estimating its impedance spectrum. The natural resonances in the frequency spectrum provide an indication of the cable's termination. Thus, by analysing the peaks in the impedance spectrum the fault location is estimated. The method focuses on finding the fault location and thus does not provide any information about the conductor's characteristics along its length, as present invention does.

Other cable monitoring methods are also disclosed in WO202123478-A1, KR101986491-B1, CN106841919-B.

Consequently, the known solutions focus on discovering a hard fault in a system or wire, and not on estimating the cable's characteristic admittance along its distance. Likewise, the known solutions are reactive, in the sense that first a fault might occur and then the methods start operating, while the method proposed in the present invention is proactive, in the sense that the cable is constantly scanned to prevent future faults originating from degradation. Several known methods can estimate the cable's characteristic admittance, but the estimated value is an average of the whole cable, and do not estimate the characteristic admittance along the conductor's length. The known methods are normally used to detect hard faults (e.g., short-circuits or open-circuits), and are not intended to be applied to discover soft faults (small and distributed degradations along the cable). Last but not least, the known methods operate after the reflection of the injected signals took place.

Description of the Invention

To overcome the drawbacks of the prior art solutions, an object of the present invention is thus to provide a condition monitoring method of an electric conductor. More particularly, the objective is to estimate the cable characteristic admittance along its length and compare it with the "healthy/original" characteristic admittance.

This object is fulfilled by a method with the characteristics of claim 1 and by a computer readable medium with the features of claim 8.

Embodiments of the present invention propose, according to one aspect, a condition monitoring method of an electric conductor, where the conductor can include a cable, a transmission line, or at least one segment of a cable/transmission line, and has a first end, a second end, and a given length. The method comprises scanning the entire length of the conductor by means of applying a voltage signal to the first end of the conductor and by measuring, by a processor, in the time domain, a current at the first end for a given sampling period, said given sampling period assuring that a reflected voltage signal doesn't reach back the first end; estimating, by a processor, a characteristic admittance of the conductor using the measured current and the voltage signal; and determining, by a processor, a health state parameter of the conductor by dividing the estimated characteristic admittance of the conductor by an original characteristic admittance of the conductor, the original characteristic admittance being calculated from conductor's parameters (e.g. conductivity, permeability, permittivity, geometrical parameters, ground resistivity, etc.) or measured when the conductor (10) is first installed.

In some embodiments, the given sampling period comprises two-times the time interval the voltage signal travels along the conductor.

In some embodiments, the voltage signal comprises a DC voltage pulse signal.

In some embodiments, the method further transforms the health state parameter to the time-domain and relates the transformed health state parameter with distance using the applied voltage signal and the given length and travelling wave speed of the conductor.

In some embodiments, the method also deconvolutes the estimated characteristic admittance of the conductor using a propagation function of the conductor.

In some embodiments, the scanning is continuously performed.

In some embodiments, a comparison between the determined health state parameter of the conductor with a threshold is executed. An alarm can be provided in case the determined health state parameter is equal to or above the threshold.

Other embodiments of the invention that are disclosed herein also include software programs to perform the method embodiment steps and operations summarized above and disclosed in detail below. More particularly, a computer program product is one embodiment that has a computer-readable medium including computer program instructions encoded thereon that when executed on at least one processor in a computer system causes the processor to perform the operations indicated herein as embodiments of the invention.

Present invention can assess the health status of any cable or transmission line by scanning the line characteristics. The advantage of the present invention compared to others is that it can discover small, soft and distributed defects along the cable, not only hard faults.

Brief Description of the Drawings

The previous and other advantages and features will be more fully understood from the following detailed description of embodiments, with reference to the attached figures, which must be considered in an illustrative and non-limiting manner, in which:

Fig. 1 schematically illustrates a generic electric conductor for application of the proposed method.

Fig. 2 is another illustration of an electric conductor.

Fig. 3 schematically illustrates different electric conductors for application of the method.

Figs. 4A, 4B and 4C show the results of having implemented the method on the electric conductors of Fig. 3.

Detailed Description of the Invention and of Preferred Embodiments

Present invention provides a condition monitoring method of electric conductors (e.g. cables, transmission lines, etc.) based on time-domain estimation of the characteristic admittance of the electric conductors.

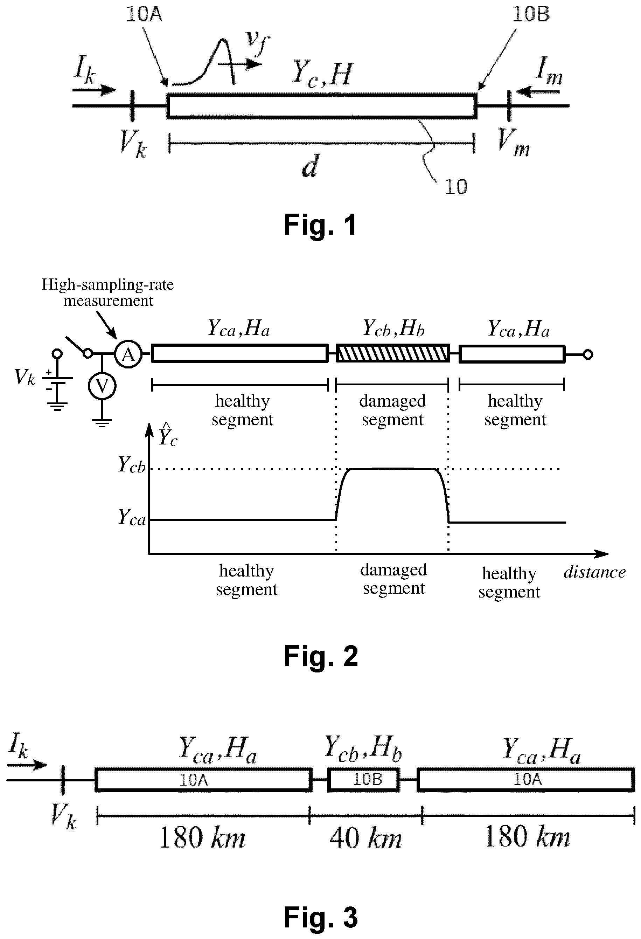

As seen in Fig. 1, a generic electric conductor 10 comprises a first end 10A or terminal k, a second end 10B or terminal m, and a given length. In an embodiment, the method comprises applying a voltage signal to the first end 10A to scan the entire length of the conductor 10. Then, a processing unit, in the time domain, measures a current at the first end for a given sampling period that assures that a reflected voltage signal doesn't reach back the first end 10A. The processing unit further estimates a characteristic admittance of the conductor 10 using the measured current and the voltage signal and determines a health state parameter of the conductor 10 by means of dividing the estimated characteristic admittance of the conductor 10 by an original characteristic admittance thereof.

In the following a more detailed description of the proposed method is provided.

In Fig. 1, $Y_c = Z^{-1}\sqrt{ZY}$ is the cable characteristic admittance, $H = e^{-l\sqrt{YZ}}$ the propagation function, $I_k$ and $V_k$ are current and voltage at first end 10A, $I_m$ and $V_m$ are current and voltage at second end 10B, Z is the cable series impedance, Y is the cable shunt admittance and I is the cable length.

The current $I_k$ in the frequency domain can be calculated as (1)

$$I_k = Y_c V_k - H(Y_c V_m + I_m) \qquad (1)$$

Before the reflection at the second end 10B, $V_m = 0$ and $I_m = 0$ and $I_k$ becomes dependent only on the voltage applied on the first end 10A ($I_k = Y_c V_k$). Thus, the electric conductor's characteristic admittance can be estimated as:

$$Y_c = \frac{I_k}{V_k} \qquad (2)$$

where $V_k$ becomes a generic voltage signal applied to the electric conductor's first end 10A and $I_k$ becomes the current measure at the same terminal, both variables in the frequency domain.

For (2) to be valid, the voltage signal should be applied and $I_k$ (in the time-domain) should be measured before the reflected wave reaches back the first end 10A again. In an embodiment, this sampling period ($\tau_f$) between the injection of the signal at the first end 10A and the reflected wave reaches back can be calculated as:

$$\tau_f = \frac{2d}{v_f} \qquad (3)$$

where d is the cable's length and $v_f$ the wave speed.

$V_k$ can be an arbitrary signal. If it is a constant DC level, for example, (2) becomes:

$$Y_c = \frac{I_k}{1/s} \qquad (4)$$

If the electric conductor 10 has a slight variation of its characteristics, $Y_c$ will also vary slightly. Thus, by dividing the estimated characteristic admittance ($\hat{Y}_c$) by the ideal $Y_c$ (that can be calculated from the electric conductor parameters or measured when the electric conductor installed), a new variable called $\hat{Y}_{c,p.u}$ can be calculated to indicated the electric conductor's state of health:

$$\frac{I_{k,measured}}{I_{k,ideal}} = \frac{\left(\frac{1}{s}\hat{Y}_c\right)}{\left(\frac{1}{s}Y_c\right)} = \frac{\hat{Y}_c}{Y_c} = \hat{Y}_{c,p.u} \tag{5}$$

An important feature of the proposed method is that $\hat{Y}_{c,p.u}$ can be transformed to the time-domain and then related with distance using $v_f$ and d. Thus, the variation of the electric conductor's characteristic admittance with distance can be obtained, revealing the electric conductor's state of health along its entire length, as illustrated in Fig. 2.

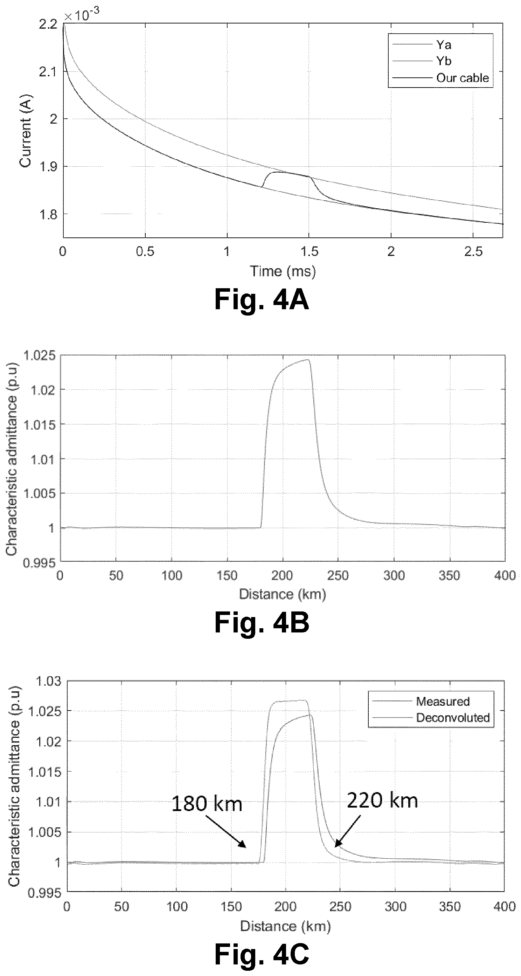

With reference now to Fig. 3, therein an example of three different electric conductors 10 is shown. Electric conductor 10A is known. Electric conductor 10B is not known but it is known that it is a variation of the cable 10A. For the condition monitoring at a first step, the measured current can be divided by the ideal current (if there was only $Y_a$), obtaining the variation as a result. Then, at a second step, since the travelling wave speed of the electric conductor 10A is known, it can be considered that said speed does not change to much and relate time with distance using the travelling wave speed. The results of the above yields to the graphs shown in Fig. 4A and 4B.

However, the wave after the first and second steps is damped by the electric conductor. The electric conductor acts like a low-pass filter. Thus, to make the admittance variation clearer, at a third step the propagation function of the electric conductor can be used to deconvolute the measured signal (deconvolute = inverse of filter to get the original signal). Fig. 4C shows the result of the deconvolution.

The present invention has been described in particular detail with respect to specific possible embodiments. Those of skill in the art will appreciate that the invention may be practiced in other embodiments. For example, the nomenclature used for components, capitalization of component designations and terms, the attributes, data structures, or any other programming or structural aspect is not significant, mandatory, or limiting, and the mechanisms that implement the invention or its features can have various different names, formats, and/or protocols. Further, the system and/or functionality of the invention may be implemented via various combinations of software and hardware, as described, or entirely in software elements. Also, particular divisions of functionality between the various components described herein are merely exemplary, and not mandatory or significant. Consequently, functions performed by a single component may, in other embodiments, be performed by multiple components, and functions performed by multiple components may, in other embodiments, be performed by a single component.

Certain aspects of the present invention include process steps or operations and instructions described herein in an algorithmic and/or algorithmic-like form. It should be noted that the process steps and/or operations and instructions of the present invention can be embodied in software, firmware, and/or hardware, and when embodied in software, can be downloaded to reside on and be operated from different platforms used by real-time network operating systems.

The scope of the present invention is defined in the following set of claims.

**Claims**

1.    A condition monitoring method of an electric conductor, the conductor (10) comprising a cable, a transmission line, or at least one segment of a cable/transmission line, and the conductor (10) having a first end (10A), a second end (10B), and a given length, the method comprising:

scanning the entire length of the conductor (10) by means of applying a voltage signal to the first end (10A) of the conductor (10) and by measuring, by a processor, in the time domain, a current at the first end (10A) for a given sampling period, said given sampling period assuring that a reflected voltage signal doesn't reach back the first end (10A);
estimating, by a processor, a characteristic admittance of the conductor (10) using the measured current and the voltage signal; and
determining, by a processor, a health state parameter of the conductor (10) by dividing the estimated characteristic admittance of the conductor (10) by an original characteristic admittance of the conductor (10), the original characteristic admittance being calculated from parameters associated to the conductor (10) or measured when the conductor (10) is installed.

2.    The method of claim 1, wherein the given sampling period comprises two-times the time interval the voltage signal travels along the conductor (10).

3. The method of claim 1 or 2, wherein the voltage signal comprises a DC voltage pulse signal.

4. The method of any one of the previous claims, further comprising transforming the health state parameter to the time-domain and further relating the transformed health state parameter with distance using at least the applied voltage signal and the given length of conductor (10).

5. The method of any one of the previous claims, further comprising deconvoluting the estimated characteristic admittance of the conductor (10) using a propagation function of the conductor (10).

6. The method of claim 1, wherein the scanning is continuously performed.

7. The method of claim 1, further comprising comparing the determined health state parameter of the conductor with a threshold, and providing an alarm if the determined health state parameter is equal or above the threshold.

8. A non-transitory computer readable medium comprising code instructions that when executed by at least one processor of a hardware system implement a method according to claim 1.

**Patentansprüche**

1. Verfahren zur Zustandsüberwachung eines elektrischen Leiters, wobei der Leiter (10) ein Kabel, eine Übertragungsleitung oder mindestens ein Segment eines Kabels/einer Übertragungsleitung umfasst, und wobei der Leiter (10) ein erstes Ende (10A), ein zweites Ende (10B) und eine gegebene Länge aufweist, wobei das Verfahren Folgendes umfasst:

das Scannen der gesamten Länge des Leiters (10) mittels des Anlegens eines Spannungssignals an das erste Ende (10A) des Leiters (10) und durch Messung, mittels eines Prozessors, im Zeitbereich, eines Stroms am ersten Ende (10A) für einen gegebenen Abtastzeitraum, wobei der genannte gegebene Abtastzeitraum gewährleistet, dass ein reflektiertes Spannungssignal nicht das erste Ende (10A) zurückreicht;
das Schätzen, mittels eines Prozessors, einer charakteristischen Admittanz des Leiters (10) unter Verwendung des gemessenen Stroms und des Spannungssignals; und
das Bestimmen, mittels eines Prozessors, eines Gesundheitszustandsparameters des Leiters (10), indem die geschätzte charakteristische Admittanz des Leiters (10) durch eine ursprüngliche charakteristische Admittanz des Leiters (10) dividiert wird, wobei die ursprüngliche charakteristische Admittanz aus Parametern, welche mit dem Leiter (10) assoziiert sind oder welche gemessen werden, wenn der Leiter (10) installiert wird, berechnet wird.

2. Verfahren nach Anspruch 1, wobei der gegebene Abtastzeitraum zweimal die Zeitspanne, in welcher das Spannungssignal entlang des Leiters (10) läuft, umfasst.

3. Verfahren nach Anspruch 1 oder 2, wobei das Spannungssignal ein Gleichspannung-Impulssignal umfasst.

4. Verfahren nach einem der vorhergehenden Ansprüche, zusätzlich umfassend das Umwandeln des Gesundheitszustandsparameters in den Zeitbereich und zusätzlich das Zuordnen des umgewandelten Gesundheitszustandsparameters mit dem Abstand unter Verwendung mindestens des angelegten Spannungssignals und der gegebenen Länge des Leiters (10).

5. Verfahren nach einem der vorhergehenden Ansprüche, zusätzlich umfassend das Entfalten der geschätzten charakteristischen Admittanz des Leiters (10) unter Verwendung einer Ausbreitungsfunktion des Leiters (10).

6. Verfahren nach Anspruch 1, wobei das Scannen kontinuierlich durchgeführt wird.

7. Verfahren nach Anspruch 1, zusätzlich umfassend das Vergleichen des bestimmten Gesundheitszustandsparameters des Leiters mit einem Schwellenwert und das Bereitstellen einer Warnmeldung, wenn der bestimmte Gesundheitszustandsparameter dem Schwellenwert gleich ist oder über dem Schwellenwert liegt.

8. Nichtflüchtiges computerlesbares Medium umfassend Codeanweisungen, welche, wenn sie mittels mindestens eines Prozessors eines Hardwaresystems ausgeführt werden, ein Verfahren nach Anspruch 1 implementieren.

**Revendications**

1. Procédé de surveillance de l'état d'un conducteur électrique, le conducteur (10) comprenant un câble, une ligne de transmission, ou au moins un segment d'un câble/ligne de transmission, et le conducteur (10) présentant une première extrémité (10A), une deuxième extrémité (10B), et une longueur donnée, le procédé comprenant :

   balayer toute la longueur du conducteur (10) par le biais de l'application d'un signal de tension à la première extrémité (10A) du conducteur (10) et en mesurant, par un processeur, dans le domaine du temps, un courant dans la première extrémité (10A) pendant une période d'échantillonnage donnée, ladite période d'échantillonnage donnée assurant qu'un signal de tension réfléchi n'arrive pas à la première extrémité (10A) ;
   estimer, par un processeur, une admittance caractéristique du conducteur (10) en utilisant le courant mesuré et le signal de tension ; et
   déterminer, par un processeur, un paramètre d'état de santé du conducteur (10) en divisant l'admittance caractéristique estimée du conducteur (10) par une admittance caractéristique originale du conducteur (10), l'admittance caractéristique originale étant calculée à partir de paramètres associés au conducteur (10) ou mesurés lorsque le conducteur (10) est installé.

2. Procédé selon la revendication 1, dans lequel la période d'échantillonnage donnée comprend deux fois l'intervalle de temps pendant lequel le signal de tension se déplace le long du conducteur (10).

3. Procédé selon la revendication 1 ou 2, dans lequel le signal de tension comprend un signal par impulsions de tension en CC.

4. Procédé selon l'une quelconque des revendications précédentes, comprenant en outre la transformation du paramètre d'état de santé dans le domaine du temps et mettant en outre en relation le paramètre d'état de santé transformé avec une distance en utilisant au moins le signal de tension appliqué et la longueur donnée du conducteur (10).

5. Procédé selon l'une quelconque des revendications précédentes, comprenant en outre la déconvolution de l'admittance caractéristique estimée du conducteur (10) en utilisant une fonction de propagation du conducteur (10).

6. Procédé selon la revendication 1, dans lequel le balayage est réalisé en continu.

7. Procédé selon la revendication 1, comprenant en outre la comparaison du paramètre d'état de santé déterminé du conducteur à un seuil, et la fourniture d'une alarme si le paramètre d'état de santé déterminé est égal ou supérieur au seuil.

8. Support non transitoire lisible par ordinateur comprenant des instructions de code qui, lorsqu'elles sont exécutées par au moins un processeur d'un système de hardware, mettent en œuvre un procédé selon la revendication 1.

**Fig. 1**

**Fig. 2**

**Fig. 3**

**Fig. 4A**

**Fig. 4B**

**Fig. 4C**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5650728 A
- US 7977950 B2
- DE 102017214996 A1
- CN 113253049 A
- CN 106383296 B
- CN 103018627 B
- CN 113075501 B
- WO 202123478 A1
- KR 101986491 B1
- CN 106841919 B